# FASCICULE DE BREVET EUROPEEN

(11) **EP 3 264 118 B1**
(45) Date de publication et mention de la délivrance du brevet: **18.07.2018**
(21) Numéro de dépôt: 17176393.1
(22) Date de dépôt: 16.06.2017
(51) Int. Cl.: G01R 31/327, H01R 9/26, H02H 3/04

(54) **SYSTÈME DE SURVEILLANCE D'UN RÉSEAU ÉLECTRIQUE**
ÜBERWACHUNGSSYSTEM EINES STROMNETZES
MONITORING SYSTEM OF AN ELECTRICAL NETWORK

(30) Priorité: 27.06.2016 FR 1655961
(43) Date de publication de la demande: 03.01.2018
(73) Titulaire: Schneider Electric Industries SAS, 92500 Rueil-Malmaison (FR)
(72) Inventeur: MARMONIER, Jean, 34130 Saint Aunes (FR)
(74) Mandataire: Dufresne, Thierry

(56) Documents cités:
- EP-A1- 0 722 092
- EP-A1- 2 887 482
- FR-A1- 2 936 908

## Description

### Domaine technique de l'invention

L'invention concerne le domaine de la surveillance pour des dispositifs de protection des réseaux électriques, et, notamment, pour des relais de protection des réseaux électriques de moyenne et haute tension, c'est-à-dire de tension supérieure à 1000V, par exemple pour des lignes aériennes ou souterraines, des départs transformateur, des départs moteur, etc...

### Etat de la technique

Dans la suite du document, le terme dispositif de protection couvre aussi bien les relais de protection que les dispositifs de mesures et de surveillance d'états d'une façon générale. Ces dispositifs de protection ont pour particularité de mesurer des données électriques représentatives du réseau électrique, telles que les valeurs de courants et/ou de tensions, qui sont fournies par des capteurs de mesure de type transformateurs de courant et/ou de tension, installés sur des conducteurs du réseau électrique.

Les données électriques sont prélevées sous format analogique par les transformateurs de courant/tension, transmises vers les dispositifs de protection par l'intermédiaire de câbles basse tension, puis converties en format numérique. Ensuite, les dispositifs de protection utilisent des programmes de traitement et d'analyse par rapport à des données de référence propres à un fonctionnement déterminé. En cas de défaillance ou d'anomalie détectée par un dispositif de protection, celui-ci peut notamment transmettre un ordre d'ouverture à des interrupteurs ou disjoncteurs de façon à sécuriser le réseau électrique et/ou informer des systèmes centraux de téléconduite (SCADA) du réseau électrique.

Néanmoins, il est important de pouvoir effectuer régulièrement des tests et des essais du bon fonctionnement des dispositifs de protection grâce à des systèmes de surveillance capables de simuler les signaux provenant des capteurs de mesure du réseau électrique, sans avoir à décâbler les connexions entre les transformateurs de courant et/ou de tension et le dispositif de protection.

Pour cela, il est connu du document FR2936908 un relais de protection d'un réseau électrique moyenne ou haute tension relié à une unité d'acquisition qui comporte une partie embase raccordée à des capteurs de mesure du réseau électrique de type transformateurs de courant et/ou de tension. Dans le but de pouvoir faire des essais fonctionnels du dispositif de protection, l'unité d'acquisition comporte également un module de test qui peut se connecter à la partie embase et qui est capable de simuler les mesures de courants/tensions faites sur le réseau électrique. Ainsi, en raccordant des moyens externes d'injection de courant/tension à ce module de test, il est alors possible de tester le fonctionnement du dispositif de protection pour simuler des transformateurs de courant et de tension.

Cependant, durant une intervention pour insérer ou changer des capteurs dans le circuit de mesure d'un dispositif de protection, il faut mettre hors service l'installation électrique pour pouvoir faire les raccordements dans le circuit de mesure du courant. Les raisons de cette mise hors service de l'installation sont d'une part la sécurité des opérateurs durant l'intervention (possibilité d'augmentation brutale de la tension aux bornes d'un transformateur de courant lors de l'ouverture du circuit du transformateur) et d'autre part l'absence momentanée d'informations arrivant au système de surveillance durant l'intervention, ce qui fait que le réseau électrique ne serait alors plus surveillé pendant cette intervention.

Une solution pourrait consister à enficher sur l'embase du module de test un équipement contenant la mesure du courant. L'avantage de cette solution est de ne pas nécessiter de mise hors service de l'installation, mais l'inconvénient est qu'il n'est plus possible de raccorder un moyen externe d'injection pour réaliser les essais fonctionnels.

Un but de l'invention est donc de remédier aux inconvénients indiqués ci-dessus et de faciliter la capacité de mettre en place simultanément un module de mesure pour surveiller les données électriques du réseau électrique et un module de test pour effectuer des tests de simulation du fonctionnement du dispositif de protection, tout cela en minimisant des manipulations potentiellement dangereuses pour des opérateurs.

### Exposé de l'invention

Ce but est atteint par un système de surveillance pour un dispositif de protection d'un réseau électrique multiphases. Le système de surveillance comprend un module de test destiné à injecter un courant ou une tension de test au dispositif de protection, une prise test raccordée entre le dispositif de protection et des capteurs de mesure du réseau électrique, la prise test comportant un premier connecteur apte à raccorder le module de test au dispositif de protection.

Le système de surveillance est caractérisé en ce qu'il comprend un module de mesure apte à être raccordé au premier connecteur de la prise test dans le but d'effectuer une ou plusieurs mesures du courant circulant dans la prise test ou de la tension aux bornes de la prise test. Le module de mesure comporte également un second connecteur apte à raccorder le module de test au dispositif de protection à travers le module de mesure.

Selon une caractéristique, la prise test comporte un premier dispositif de shunt qui est mobile entre une position fermée permettant de raccorder le dispositif de protection aux capteurs de mesure du réseau électrique et une position ouverte.

Selon une autre caractéristique, le module de mesure comprend un dispositif d'ouverture apte à entraîner le premier dispositif de shunt en position ouverte lorsque le module de mesure est raccordé au premier connecteur de la prise test. Le module de mesure comprend un second dispositif de shunt qui est mobile entre une position fermée permettant de raccorder le dispositif de protection aux capteurs de mesure du réseau électrique et une position ouverte.

Selon une autre caractéristique, le module de test comprend un dispositif d'ouverture apte à entraîner le premier dispositif de shunt en position ouverte lorsque le module de test est raccordé au premier connecteur de la prise test ou pour passer le second dispositif de shunt en position ouverte lorsque le module de test est raccordé au second connecteur du module de mesure. Le premier et le second dispositif de shunt comportent pour chaque phase deux languettes élastiques qui sont en contact l'une avec l'autre en position fermée et le dispositif d'ouverture comporte pour chaque phase une pièce isolante destinée à s'insérer entre deux languettes élastiques d'une même phase.

L'invention couvre aussi un dispositif de protection d'un réseau électrique multiphases comprenant un tel système de surveillance.

### Brève description des figures

D'autres caractéristiques vont apparaître dans la description détaillée qui suit faite en regard des dessins annexés dans lesquels :
- la figure 1 montre un schéma d'un système de surveillance connu avec un dispositif de protection connecté à des capteurs de courant d'un réseau électrique au travers d'une prise test,
- la figure 2 représente de façon simplifiée le schéma d'un module de test permettant d'injecter du courant dans le dispositif de protection et la figure 3 reprend le schéma de la figure 1 avec l'adjonction du module de test de la figure 2,
- la figure 4 représente de façon simplifiée le schéma d'un module de mesure selon l'invention et la figure 5 reprend le schéma de la figure 1 avec l'adjonction d'un module de test et d'un module de mesure,
- la figure 6 présente une variante de la figure 5, avec l'utilisation de mesures de tension au lieu de mesures de courant, et la figure 7 détaille un bouchon utilisé dans le cadre de cette variante.

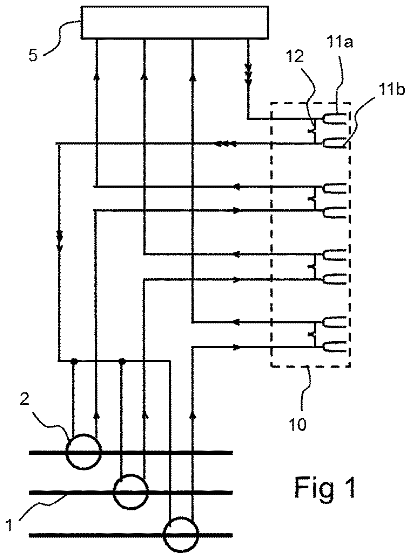

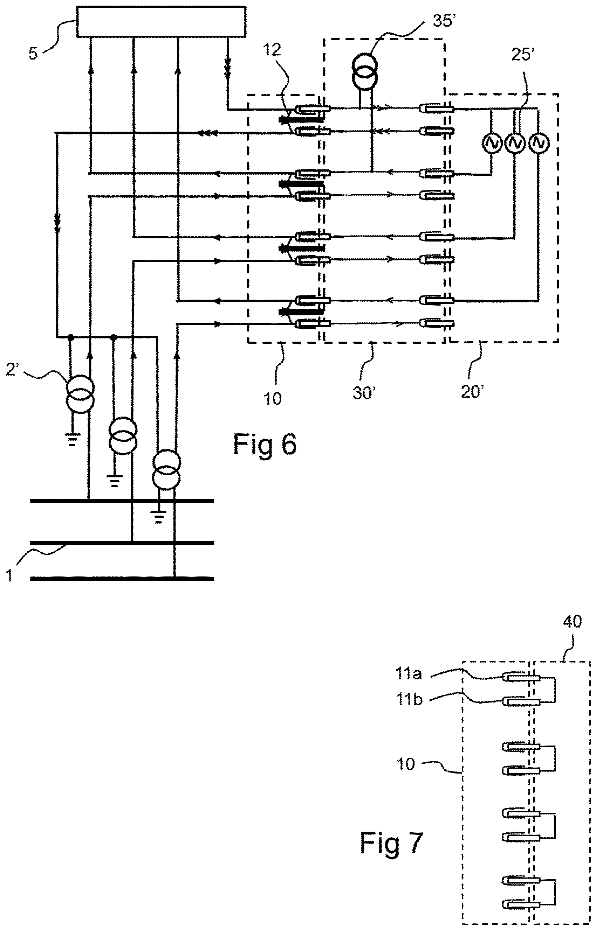

En référence à l'exemple de la figure 1, un dispositif de protection 5 est relié à des capteurs 2 d'un réseau électrique triphasé 1 moyenne ou haute tension au travers d'une prise test 10. De façon connue, le dispositif de protection 5 est destiné notamment à surveiller le réseau électrique 1 à l'aide de mesures représentatives du courant circulant dans le réseau ou de la tension phase-neutre du réseau électrique 1. L'exemple de la figure 1 montre ainsi des capteurs de courant 2, de type transformateurs de courant, enroulés autour de chaque phase du réseau électrique 1 pour mesurer le courant circulant dans les phases du réseau électrique 1. Dans la variante de la figure 6, les capteurs de courant 2 sont remplacés par des capteurs de tension 2' qui mesurent les tensions phase-neutre du réseau électrique 1.

La prise test 10 comprend un connecteur, appelé premier connecteur, qui est composé, pour chaque phase et pour le neutre, de deux bornes de connexion 11a, 11b permettant de raccorder la prise test 10 à d'éventuels autres appareils. La prise test 10 comprend aussi un premier dispositif de shunt 12 qui permet de garder fermé le circuit électrique entre les transformateurs de courant 2 du réseau électrique et le dispositif de protection 5 lorsqu'aucun appareil n'est relié à la prise test 10. Ce dispositif de shunt 12 est en effet primordial car une ouverture intempestive du circuit électrique des transformateurs de courant 2 engendrerait des problèmes de sécurité importants.

Selon le mode de réalisation présenté dans les figures, ce premier dispositif de shunt 12 comprend deux languettes conductrices élastiques reliées chacune à une borne de connexion 11a, respectivement 11b d'une même phase. Le dispositif de shunt 12 est mobile entre une position dite fermée et une position dite ouverte. En l'absence de toute fiche introduite dans la prise test 10, le premier dispositif de shunt 12 est en position fermée car l'élasticité des languettes conductrices fait qu'elles restent en contact l'une avec l'autre, permettant ainsi de shunter les bornes de connexion 11a, 11b correspondantes et donc de maintenir fermé le circuit électrique de mesure entre les transformateurs de courant 2 et le dispositif de protection 5. Lorsqu'une fiche isolante est introduite dans la prise test 10, le premier dispositif de shunt 12 est en position ouverte car la fiche isolante écarte les languettes élastiques et les bornes de connexion 11a, 11b correspondantes ne sont plus shuntées.

D'autres modes de réalisation pour le dispositif de shunt sont possibles. Par exemple, le premier dispositif de shunt peut comprendre deux pattes conductrices fixes qui sont connectables entre elles par une pièce métallique mobile assurant le shunt grâce à la pression d'un ressort. Lorsqu'une fiche isolante est introduite dans la prise test, cette fiche isolante vient repousser la pièce métallique en comprimant le ressort et ouvrant ainsi le contact entre les deux pattes conductrices.

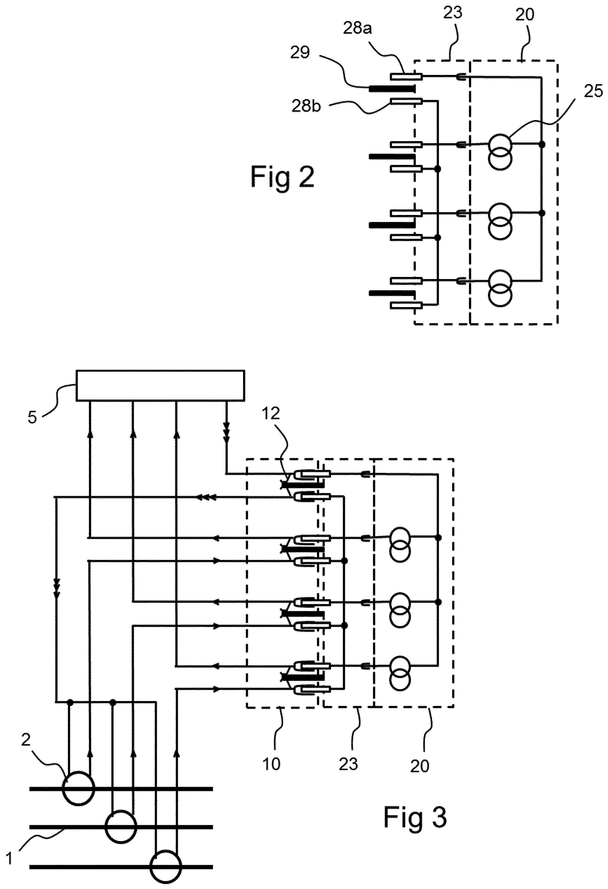

Un des intérêts de la présence d'une prise test 10 est de pouvoir injecter du courant à partir d'une source extérieure, telle qu'un générateur de test, en remplacement des courants mesurés par les capteurs de courant 2, ceci afin de pouvoir tester à tout moment le fonctionnement du dispositif de protection 5, en simulant différentes situations à partir du courant injecté par la source extérieure. Pour cela, il suffit de raccorder un module de test 20 à la fiche test 10, comme représenté dans les figures 2 et 3.

Le module de test 20 comprend deux fiches de connexion 28a, 28b et un dispositif d'ouverture 29 pour chaque phase et pour le neutre. Le dispositif d'ouverture est par exemple constitué par une fiche isolante 29 située entre les deux fiches de connexion 28a, 28b d'une même phase. Lors de la connexion du module de test 20 dans la prise test 10, les fiches de connexion 28a, respectivement 28b, viennent se raccorder électriquement avec les bornes de connexion 11a, respectivement 11b, correspondantes de la prise test 10 et la fiche isolante 29 vient s'insérer entre les deux languettes élastiques correspondantes du premier dispositif de shunt 12, ce qui provoque leur écartement et donc la déconnexion du dispositif de shunt 12.

Le module de test 20 comprend également au moins un générateur de courant 25 destiné à injecter des courants de test afin de faire des essais du dispositif de protection 5. Préférentiellement, le module de test 20 comprend un générateur de courant 25 pour chaque phase. Chaque générateur de courant 25 est relié entre la borne 28a de la phase et la borne 28a du neutre. De plus, les fiches de connexion 28b de chaque phase et du neutre sont raccordées entre elles. Les fiches isolantes 29 sont agencées pour que le circuit électrique des transformateurs de courant 2 se reboucle au travers des fiches de connexion 28b avant que les fiches isolantes 29 n'ouvrent les dispositifs de shunt 12 de chaque phase, évitant ainsi une ouverture intempestive de ce circuit.

Grâce à cet agencement, un module de test 20 peut donc être raccordé sur la prise test 10 dans le but de faire des simulations d'injection de courant et faire ainsi des essais fonctionnels du dispositif de protection 5. Avantageusement, ce raccordement connecte automatiquement le dispositif de protection 5 au module de test 20 tout en maintenant la continuité du circuit des transformateurs de courant 2 lors de cette connexion. Elle est donc très simple et ne nécessite pas de manipulation particulière des opérateurs.

Dans l'exemple des figures 2 et 3, le module de test 20 comporte également une prise interface 23 qui contient le raccordement des fiches de connexion 28b entre elles. Indifféremment, cette prise interface 23 est soit intégrée directement dans le module de test 20, soit est un élément séparé, par exemple dans le cas où les connectiques du module de test 20 et de la fiche test 10 ne seraient pas compatibles. En effet le module de test 20 peut être un générateur extérieur adapté pour des usages et applications très divers, et qui est donc livré avec des fiches de connexion standard du marché, par exemple de type fiche banane. Celles-ci qui ne sont pas forcément compatibles avec les bornes de connexion 11a, 11b de la fiche test 10, d'où l'intérêt d'avoir une prise interface 23 distincte du module de test 20.

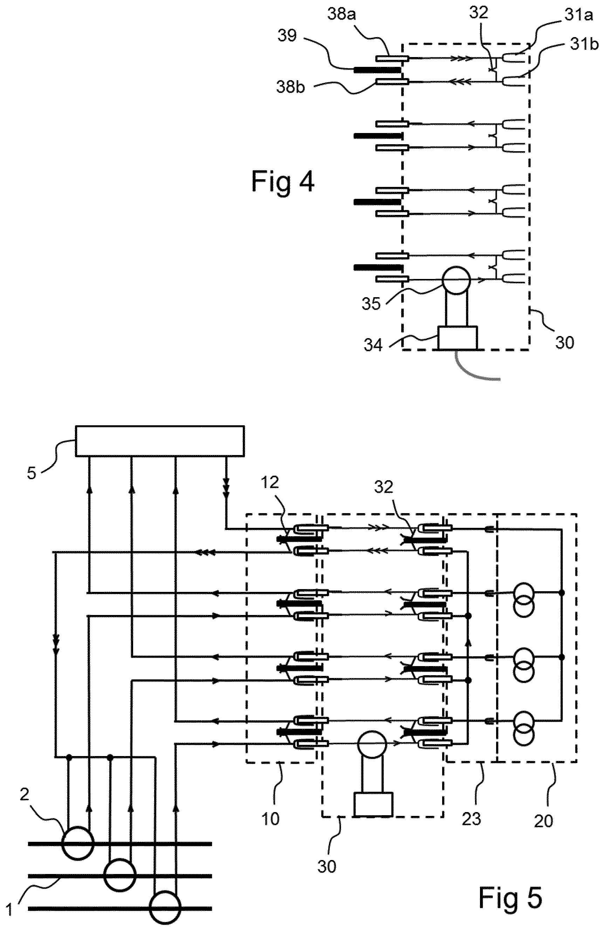

La figure 4 représente un module de mesure 30 qui est destiné à être raccordé à une prise test 10 dans le but de faire des mesures de courant. Ce module de mesure 30 peut être utilisé pour équiper l'installation électrique d'un équipement de mesure non prévu initialement ou pour effectuer une mesure de courant supplémentaire au niveau d'un dispositif de protection 5. Ceci se fait par simple insertion du module de mesure 30 dans la prise test 10, donc sans aucune interruption du fonctionnement de l'installation électrique et avec un temps d'installation extrêmement réduit par rapport à une méthode classique qui demanderait de reprendre le câblage de l'installation.

De la même façon que pour le module de test 20, le module de mesure 30 comprend deux fiches de connexion 38a, 38b et une fiche isolante 39. Lors de la connexion du module de mesure 30 dans la prise test 10, les fiches de connexion 38a, 38b viennent se raccorder électriquement avec les bornes de connexion 11a, 11b correspondantes de la prise test 10 et la fiche isolante 39 vient s'insérer entre les deux languettes élastiques du dispositif de shunt 12 correspondant, ce qui provoque leur écartement et donc la déconnexion du dispositif de shunt 12.

Le module de mesure 30 comprend au moins un capteur de courant 35 qui mesure le courant issu de l'un des transformateurs de courant 2. Le capteur de courant 35 est relié à un dispositif 34 qui comprend notamment un convertisseur analogique/digital et des moyens de communication pour transférer les mesures effectuées vers tout équipement externe distant. Pour des raisons de clarté dans les figures, un capteur de courant 35 est montré pour seulement une phase, mais il est bien évident que le module de mesure 30 comporte préférentiellement un capteur de courant 35 pour chacune des phases du réseau électrique.

Cependant lorsqu'un module de mesure 30 est déjà raccordé à la prise test 10, il serait intéressant de pouvoir aussi raccorder un module de test 20 lorsque l'on souhaite assurer également des essais fonctionnels sur le dispositif de protection 5. L'intérêt de la solution serait en effet de pouvoir bénéficier simultanément des fonctionnalités de ces deux modules.

C'est pourquoi le module de mesure 30 comporte, du côté opposé aux fiches de connexion 38a, 38b, un connecteur, appelé second connecteur, qui est composé de deux bornes de connexion 31a, 31b pour chaque phase et pour le neutre, et un second dispositif de shunt 32. Le second dispositif de shunt 32 comprend deux languettes conductrices élastiques reliées chacune à une borne de connexion 31a, respectivement 31b d'une même phase et permet de garder fermé le circuit électrique entre les transformateurs de courant 2 et le dispositif de protection 5 lorsqu'aucun appareil n'est relié aux bornes de connexion 31a, 31b du module de mesure 30. Le second connecteur et le second dispositif de shunt du module de mesure 30 sont similaires au premier connecteur et au premier dispositif de shunt de la prise test 10 et leur fonctionnement est identique.

Ainsi, comme indiqué sur la figure 5, le module de mesure 30 est raccordé à la prise test 10, via les éléments 11a, 11b, 12 coopérant avec les éléments 38a, 38b, 39; et le module de test 20 est raccordé au module de mesure 30, via les éléments 31a, 31b, 32 coopérant avec les éléments 28a, 28b, 29. Le module de test 20 est donc raccordé au dispositif de protection 5 à travers le module de mesure 30. Grâce à cet agencement, il est possible de combiner simultanément les fonctionnalités offertes par un module de test 20 et par un module de mesure 30.

Les exemples précédents ont été présentés avec l'utilisation de mesures et d'injections de courant. Mais le système de surveillance selon l'invention peut aussi être basé sur des mesures et des injections de tension. La figure 6 montre donc une variante de l'invention, dans laquelle les capteurs de mesure du réseau électrique 1 sont des capteurs de tension 2', de type transformateurs de tension, au lieu des capteurs de courant 2. De même, le système de surveillance comprend un module de test 20' qui est capable d'injecter une tension pour chaque phase au dispositif de protection 5 par l'intermédiaire de générateurs de tension 25', en remplacement des générateurs de courant 25. De même, le système de surveillance comprend un module de mesure 30' qui s'insère entre la prise test 10 et le module de test 20' et qui comprend un ou plusieurs capteurs de tension 35' entre phases et neutre, en remplacement des capteurs de courant 35.

Dans cette variante avec mesure de tension, le système de surveillance peut utiliser des dispositifs de shunt et pièces isolantes identiques à ceux décrits précédemment. Néanmoins, comme l'ouverture d'un circuit de mesure comprenant un transformateur de tension 2' ne présente pas le même danger qu'avec les transformateurs de courant 2, ces dispositifs de shunt et pièces isolantes ne sont pas obligatoires. Ils peuvent être remplacés par un dispositif plus simple, comme un bouchon amovible 40 représenté en figure 7 et qui permet de raccorder chaque borne de connexion 11a avec la borne de connexion adjacente 11b. Ainsi, lorsqu'un tel bouchon 40 est raccordé à la prise test 10, cela permet de fermer le circuit de mesure entre les capteurs de tension 2' et le dispositif de protection 5. Lorsqu'on veut connecter un module de mesure 30 ou un module de test 20 à la prise test 10, on retire au préalable ce bouchon 40.

## Revendications

1. Système de surveillance destiné à un dispositif de protection (5) d'un réseau électrique multiphases (1), le système comprenant :
- un module de test (20) qui est destiné à injecter un courant ou une tension de test au dispositif de protection (5),
- une prise test (10) raccordée entre le dispositif de protection (5) et des capteurs de mesure (2) du réseau électrique, la prise test (10) comportant un premier connecteur (11a, 11b) apte à raccorder le module de test (20) au dispositif de protection (5),
le système étant **caractérisé en ce qu'**il comprend :
- un module de mesure (30) apte à être raccordé au premier connecteur (11a, 11b) de la prise test (10) dans le but d'effectuer une ou plusieurs mesures du courant circulant dans la prise test (10) ou de la tension aux bornes de la prise test (10),
- le module de mesure (30) comportant également un second connecteur (31a, 31b) apte à raccorder le module de test (20) au dispositif de protection (5) à travers le module de mesure (30).

2. Système de surveillance selon la revendication 1, **caractérisé en ce que** la prise test (10) comporte un premier dispositif de shunt (12) qui est mobile entre une position fermée permettant de raccorder le dispositif de protection (5) aux capteurs de mesure (2) du réseau électrique et une position ouverte.

3. Système de surveillance selon la revendication 2, **caractérisé en ce que** le module de mesure (30) comprend un dispositif d'ouverture (39) apte à entraîner le premier dispositif de shunt (12) en position ouverte lorsque le module de mesure (30) est raccordé au premier connecteur (11a, 11b) de la prise test (10).

4. Système de surveillance selon la revendication 3, **caractérisé en ce que** le module de mesure (30) comprend un second dispositif de shunt (32) qui est mobile entre une position fermée permettant de raccorder le dispositif de protection (5) aux capteurs de mesure (2) du réseau électrique et une position ouverte.

5. Système de surveillance selon la revendication 4, **caractérisé en ce que** le module de test (20) comprend un dispositif d'ouverture (29) apte à entraîner le premier dispositif de shunt (12) en position ouverte lorsque le module de test (20) est raccordé au premier connecteur (11a, 11b) de la prise test (10) ou pour passer le second dispositif de shunt (32) en position ouverte lorsque le module de test (20) est raccordé au second connecteur (31a, 31b) du module de mesure (30).

6. Système de surveillance selon la revendication 5, **caractérisé en ce que** le premier et le second dispositif de shunt (12, 32) comportent pour chaque phase deux languettes élastiques qui sont en contact l'une avec l'autre en position fermée et le dispositif d'ouverture comporte pour chaque phase une pièce isolante (29, 39) destinée à s'insérer entre deux languettes élastiques d'une même phase.

7. Système de surveillance selon la revendication 1, **caractérisé en ce que**, pour au moins une phase, le module de mesure (30) comprend au moins un capteur de courant (35) qui est relié à un convertisseur analogique numérique (34).

8. Dispositif de protection d'un réseau électrique multiphases, **caractérisé en ce qu'**il comprend un système de surveillance selon l'une des revendications précédentes.

## Patentansprüche

1. Überwachungssystem, das für eine Schutzvorrichtung (5) eines Mehrphasen-Stromnetzes (1) bestimmt ist, wobei das System enthält:
- ein Testmodul (20), das dazu bestimmt ist, einen Teststrom oder eine Testspannung in die Schutzvorrichtung (5) einzuspeisen,
- einen Teststecker (10), der zwischen der Schutzvorrichtung (5) und Messern (2) des Stromnetzes angeschlossen ist, wobei der Teststecker (10) einen ersten Verbinder (11a, 11b) aufweist, der das Testmodul (20) an die Schutzvorrichtung (5) anschließen kann,
wobei das System **dadurch gekennzeichnet ist, dass** es enthält:
- ein Messmodul (30), das an den ersten Verbinder (11a, 11b) des Teststeckers (10) angeschlossen werden kann, um eine oder mehrere Messungen des im Teststecker (10) fließenden Stroms oder der Spannung an den Klemmen des Teststeckers (10) durchzuführen,
- wobei das Messmodul (30) ebenfalls einen zweiten Verbinder (31a, 31b) aufweist, der das Testmodul (20) über das Messmodul (30) an die Schutzvorrichtung (5) anschließen kann.

2. Überwachungssystem nach Anspruch 1, **dadurch gekennzeichnet, dass** der Teststecker (10) eine erste Shunt-Vorrichtung (12) aufweist, die zwischen einer geschlossenen Stellung, die es ermöglicht, die Schutzvorrichtung (5) an die Messer (2) des Stromnetzes anzuschließen, und einer offenen Stellung beweglich ist.

3. Überwachungssystem nach Anspruch 2, **dadurch gekennzeichnet, dass** das Messmodul (30) eine Öffnungsvorrichtung (39) enthält, die die erste Shunt-Vorrichtung (12) in die offene Stellung antreiben kann, wenn das Messmodul (30) an den ersten Verbinder (11a, 11b) des Teststeckers (10) angeschlossen ist.

4. Überwachungssystem nach Anspruch 3, **dadurch gekennzeichnet, dass** das Messmodul (30) eine zweite Shunt-Vorrichtung (32) enthält, die zwischen einer geschlossenen Stellung, die es ermöglicht, die Schutzvorrichtung (5) an die Messer (2) des Stromnetzes anzuschließen, und einer offenen Stellung beweglich ist.

5. Überwachungssystem nach Anspruch 4, **dadurch gekennzeichnet, dass** das Testmodul (20) eine Öffnungsvorrichtung (29) enthält, die die erste Shunt-Vorrichtung (12) in die offene Stellung antreiben kann, wenn das Testmodul (20) an den ersten Verbinder (11a, 11b) des Teststeckers (10) angeschlossen ist, oder um die zweite Shunt-Vorrichtung (32) in die offene Stellung zu bringen, wenn das Testmodul (20) an den zweiten Verbinder (31a, 31b) des Messmoduls (30) angeschlossen ist.

6. Überwachungssystem nach Anspruch 5, **dadurch gekennzeichnet, dass** die erste und die zweite Shunt-Vorrichtung (12, 32) für jede Phase zwei elastische Zungen aufweisen, die in der geschlossenen Stellung miteinander in Kontakt sind, und die Öffnungsvorrichtung für jede Phase ein Isolierbauteil (29, 39) aufweist, das dazu bestimmt ist, sich zwischen zwei elastische Zungen einer gleichen Phase einzufügen.

7. Überwachungssystem nach Anspruch 1, **dadurch gekennzeichnet, dass**, für mindestens eine Phase, das Messmodul (30) mindestens einen Stromsensor (35) enthält, der mit einem Analog-Digital-Wandler (34) verbunden ist.

8. Schutzvorrichtung eines elektrischen Mehrphasennetzes, **dadurch gekennzeichnet, dass** sie ein Überwachungssystem nach einem der vorhergehenden Ansprüche enthält.

## Claims

1. Monitoring system intended for a device (5) for protecting a multiphase electrical network (1), the system comprising:
- a test module (20) that is intended to inject a test current or a test voltage at the protection device (5),
- a test plug (10) connected between the protection device (5) and measurement sensors (2) of the electrical network, the test plug (10) including a first connector (11a, 11b) able to connect the test module (20) to the protection device (5),
the system being **characterized in that** it comprises:
- a measurement module (30) able to be connected to the first connector (11a, 11b) of the test plug (10) for the purpose of carrying out one or more measurements of the current flowing in the test plug (10) or of the voltage across the terminals of the test plug (10),
- the measurement module (30) also including a second connector (31a, 31b) able to connect the test module (20) to the protection device (5) through the measurement module (30).

2. Monitoring system according to Claim 1, **characterized in that** the test plug (10) includes a first shunt device (12) that is able to move between a closed position, making it possible to connect the protection device (5) to the measurement sensors (2) of the electrical network, and an open position.

3. Monitoring system according to Claim 2, **characterized in that** the measurement module (30) comprises an opening device (39) able to drive the first shunt device (12) into the open position when the measurement module (30) is connected to the first connector (11a, 11b) of the test plug (10).

4. Monitoring system according to Claim 3, **characterized in that** the measurement module (30) comprises a second shunt device (32) that is able to move between a closed position, making it possible to connect the protection device (5) to the measurement sensors (2) of the electrical network, and an open position.

5. Monitoring system according to Claim 4, **characterized in that** the test module (20) comprises an opening device (29) able to drive the first shunt device (12) into the open position when the test module (20) is connected to the first connector (11a, 11b) of the test plug (10) or to switch the second shunt device (32) to the open position when the test module (20) is connected to the second connector (31a, 31b) of the measurement module (30).

6. Monitoring system according to Claim 5, **characterized in that** the first and the second shunt device (12, 32) include, for each phase, two flexible tabs that are in contact with one another in the closed position, and the opening device includes, for each phase, an insulating part (29, 39) that is intended to be inserted between two flexible tabs of one and the same phase.

7. Monitoring system according to Claim 1, **characterized in that**, for at least one phase, the measurement module (30) comprises at least one current sensor (35) that is linked to an analogue-to-digital converter (34).

8. Device for protecting a multiphase electrical network, **characterized in that** it comprises a monitoring system according to one of the preceding claims.
